(19) **Europäisches Patentamt / European Patent Office / Office européen des brevets**

(11) **EP 3 453 045 B1**

(12) **FASCICULE DE BREVET EUROPEEN**

(45) Date de publication et mention de la délivrance du brevet:
**31.07.2019 Bulletin 2019/31**

(51) Int Cl.:
*H01J 27/00* (2006.01)     *H01J 37/02* (2006.01)
*C23C 14/48* (2006.01)     *C03C 23/00* (2006.01)

(21) Numéro de dépôt: **18723406.7**

(22) Date de dépôt: **12.04.2018**

(86) Numéro de dépôt international:
**PCT/EP2018/000200**

(87) Numéro de publication internationale:
**WO 2018/188804 (18.10.2018 Gazette 2018/42)**

(54) **PROCEDE D'IMPLANTATION D'IONS MONO- OU MULTICHARGES SUR UNE SURFACE D'UN OBJET A TRAITER ET INSTALLATION POUR LA MISE EN OEUVRE DE CE PROCEDE**

IMPLANTATIONSVERFAHREN VON MEHRFACH GELADENEN IONEN IN EINE OBERFLÄCHE EINES ZU BEHANDELNDEN OBJEKTS, UND ANLAGE FÜR DIE UMSETZUNG DIESES VERFAHRENS

METHOD FOR IMPLANTING MULTI-CHARGED IONS ON A SURFACE OF AN OBJECT TO BE TREATED AND INSTALLATION FOR IMPLEMENTING SAID METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.04.2017 EP 17166644**

(43) Date de publication de la demande:
**13.03.2019 Bulletin 2019/11**

(73) Titulaire: **The Swatch Group Research and Development Ltd**
**2074 Marin (CH)**

(72) Inventeurs:
• **VUILLE, Pierry**
  **2338 Les Emibois (CH)**
• **COCHAND, Roger**
  **1974 Arbaz (CH)**
• **BAZIN, Jean-Luc**
  **2512 Tüscherz-Alfermée (CH)**
• **MIKO, Csilla**
  **1417 Essertines-sur-Yverdon (CH)**
• **KOOL, Arne**
  **1807 Blonay (CH)**

(74) Mandataire: **ICB SA**
**Faubourg de l'Hôpital, 3**
**2001 Neuchâtel (CH)**

(56) Documents cités:
**WO-A1-2015/176850     GB-A- 2 084 792**
**US-A- 4 278 890     US-A- 4 361 762**
**US-A- 5 136 171     US-A1- 2015 376 058**

EP 3 453 045 B1

**Description**

Domaine technique de l'invention

La présente invention a pour objet un procédé de traitement de la surface d'un objet, notamment mais non exclusivement en saphir synthétique, au moyen d'un faisceau d'ions mono- ou multichargés. Ce procédé vise à réduire les réflexions parasites de la surface d'un objet par exemple réalisé en saphir synthétique et à améliorer durablement la transmission de la lumière d'un tel matériau dans le spectre des longueurs d'onde du domaine visible. Le procédé selon l'invention est notamment destiné à être appliqué au traitement antireflet d'une surface d'un verre de montre en saphir synthétique afin d'améliorer ses caractéristiques de transmission de la lumière. Dans ces conditions, la surface du verre de montre présente de bonnes propriétés antireflets dans le domaine de la lumière visible. Plus généralement, la présente invention s'applique à tout type de matériau conducteur de l'électricité, semi-conducteur ou électriquement isolant, dans le but d'améliorer les caractéristiques mécaniques, en particulier la résistance aux rayures, de la surface des objets réalisés à l'aide de tels matériaux au moyen du procédé d'implantation ionique selon l'invention. En outre, la présente invention concerne un installation pour la mise en oeuvre de ce procédé.

Arrière-plan technologique de l'invention

Les saphirs ou corindons sont constitués de cristaux d'oxyde d'aluminium (Al2O3) dont la couleur est déterminée par la présence d'impuretés (oxydes) présents dans ces matériaux à l'état de traces. On sait ainsi que la présence de titane et de fer donne à un saphir une couleur bleue, la présence de vanadium une couleur violette et la présence de chrome une couleur rose. Enfin, la présence de fer dans un saphir donne à celui-ci un aspect jaune ou vert.

Cette coloration s'explique par le fait que les impuretés font apparaître, à l'intérieur de la bande interdite du corindon, des niveaux d'énergie qui modifient les spectres d'émission et d'absorption du matériau et donc sa couleur.

Le saphir peut être traité thermiquement ; les pierres trop claires, trop sombres ou avec beaucoup d'inclusions sont chauffées. Ce processus thermique permet de rehausser la couleur et d'améliorer l'éclat des pierres en permettant de dissoudre les impuretés présentes à l'état de traces dans la pierre.

Depuis le début du XIX$^{ème}$ siècle, on sait fabriquer en laboratoire des saphirs et des rubis synthétiques. La composition chimique et les propriétés physiques de ces pierres synthétiques sont les mêmes que celles des pierres naturelles. Les pierres synthétiques peuvent cependant être distinguées des pierres naturelles par leurs lignes de cristallisation généralement incurvées, du moins pour les productions les plus anciennes.

En raison de sa forte résistance aux rayures, le saphir synthétique est notamment utilisé pour réaliser des verres de montres ou bien des lentilles dans les appareils optiques de prise de vues, notamment dans les smartphones. La fabrication de saphir synthétique s'effectue aujourd'hui à une échelle industrielle.

Il est bien connu qu'une surface en saphir synthétique réfléchit environ 15% de la lumière incidente, ce qui est gênant pour lire des informations affichées par un cadran de montre, un écran plat d'ordinateur ou de téléphone mobile.

Cette valeur de réflectivité de la lumière par une surface en saphir synthétique est obtenue à l'aide des relations de Fresnel qui donnent pour un rayon lumineux traversant un dioptre sous un angle d'incidence de 90° les coefficients de réflexion (R) et de transmission (T) suivants :

$$R = ((n2-n1)/(n2+n1))^2$$

$$T = 4n1*n2/(n2+n1)^2$$

où n1 et n2 sont les indices de réflexion des milieux séparés par le dioptre.

En tenant compte du principe de conservation de l'énergie, on obtient R+T = 1.

Pour de l'air (n1 = 1) et du saphir synthétique (n2 = 1,76), on obtient avec les formules ci-dessus : R = 0,0758, T = 1-R = 0,9242. Autrement dit, 7,6% de la lumière visible qui tombe perpendiculairement sur une surface en saphir synthétique est réfléchi, et 92,4% de cette lumière est transmis.

Pour une lame de saphir synthétique constituée d'une face d'entrée et d'une face de sortie qui s'étendent parallèlement à et à distance l'une de l'autre, les pertes optiques sont deux fois supérieures et sont donc de l'ordre de 15%. Cette forte réflexion de la lumière ambiante rend malaisée la lecture des informations affichées par exemple par un cadran de montre (aiguilles, indication de quantième, décors) situé sous le verre de montre en saphir synthétique.

Il existe des procédés antireflets consistant à effectuer des dépôts d'oxydes métalliques dont la mise en oeuvre est relativement complexe et coûteuse. Par exemple, pour des verres de montres, l'un des procédés utilisé consiste à déposer sous vide (10$^{-5}$ torr) des couches minces d'oxydes métalliques. Dans des enceintes hors poussières du type salle blanche, les verres de montres sont d'abord nettoyés dans des chaînes de lavage puis séchés aux ultrasons. Ces verres de montres sont ensuite montés sur des supports qui sont introduits dans des cloches à vide. Le vide qui règne à l'intérieur de ces cloches permet l'évaporation d'un oxyde métallique par sublimation à une température moins élevée que sous pression atmosphérique. L'évaporation peut se faire en chauffant l'oxyde métallique par effet Joule ou bien en bombardant l'oxyde à l'aide d'un canon à électrons. Il faut parfaitement contrôler la qualité du vide, la vitesse d'évaporation et les épaisseurs de couches déposées. Ces épaisseurs doivent bien sûr être uniformes.

Il existe d'autres types de dépôts en phase vapeur (également connus sous leur dénomination anglosaxonne Physical Vapor Déposition ou PVD) moins coûteux qui consistent à effectuer des dépôts de fluorure de magnésium MgF2 (indice de réfraction optique 1,38) ou de cryolite Na3A1F6 (indice de réfraction optique 1,35). Les indices de réfraction de ces matériaux sont proches l'un de l'autre, mais leurs propriétés de résistance aux rayures sont inférieures à celles du saphir synthétique. Les dépôts PVD effectués sur du saphir synthétique dans le but d'améliorer ses propriétés antireflets peuvent se rayer, voire s'écailler, réduisant ainsi à néant tout l'intérêt que l'on peut avoir pour le saphir synthétique.

On entend par " saphir synthétique" un matériau transparent à la lumière visible. Le saphir synthétique est constitué d'oxyde d'aluminium (Al203). Du point de vue physique, le saphir synthétique est un matériau cristallin très dur (dureté égale à 9 sur l'échelle de Mohs) appartenant à la famille des corindons et qui présente un indice de réfraction très élevé égal à 1,76.

De manière plus générale, la présente invention s'intéresse à tout type de matériau tel que, non limitativement, le saphir synthétique, le polycarbonate, le verre minéral ou bien encore les céramiques. Les matériaux à traiter peuvent être conducteurs de l'électricité ou semiconducteurs ou bien électriquement isolants.

D'autres techniques de traitement de surface connues consistent à implanter des ions dans la surface d'un objet à traiter.

Ces procédés d'implantation ionique consistent à bombarder la surface de l'objet à traiter par exemple au moyen d'une source d'ions mono- ou multichargés du type à résonance cyclotron électronique. Une telle installation est encore connue sous sa dénomination anglosaxonne Electron Cyclotron Resonance ou ECR.

Une source d'ions ECR fait usage de la résonance cyclotronique des électrons pour créer un plasma. Des micro-ondes sont injectées dans un volume de gaz à basse pression destiné à être ionisé, à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules et provoquent leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions simplement chargés, c'est-à-dire des ions dont le degré d'ionisation est égal à 1, ou bien des ions multichargés, c'est-à-dire des ions dont le degré d'ionisation est supérieur à 1.

Dans le cadre de la présente demande de brevet, on s'intéresse à une source d'ions mono- ou multichargés du type à résonance cyclotron électronique ECR. Très schématiquement, et comme illustré sur la figure 1 annexée à la présente demande de brevet, une source d'ions ECR, désignée dans son ensemble par la référence numérique générale 1, comprend un étage d'injection 2 dans lequel on introduit un volume 4 de gaz à ioniser et une onde hyperfréquence 6, un étage de confinement magnétique 8 dans lequel est créé un plasma 10, et un étage d'extraction 11 qui permet d'extraire et d'accélérer les ions du plasma 10 au moyen d'une anode 11a et d'une cathode 11b entre lesquelles est appliquée une haute tension.

L'aspect du faisceau d'ions 12 produit en sortie de la source d'ions mono- ou multichargés ECR 1 est illustré à la figure 2 annexée à la présente demande de brevet. On remarque que ce faisceau d'ions 12 a tendance à diverger à sa sortie de la source d'ions ECR 1, ce qui s'explique par le fait que les ions, qui sont tous de même signe électrique, ont tendance à se repousser mutuellement. Comme le faisceau d'ions 12 tend à diverger en sortie de la source d'ions ECR 1, cela pose des problèmes d'inhomogénéité de la distribution des ions à la surface de l'objet à traiter.

Un autre problème lié à l'implantation d'ions sur la surface d'un objet à traiter se trouve dans l'apparition d'un potentiel électrostatique à la surface de l'objet à traiter au fur et à mesure que les ions monochargés ou multichargés se déposent. En effet, plus les ions sont nombreux à être implantés à la surface de l'objet à traiter, plus le champ électrostatique est élevé, et plus la surface de l'objet à traiter tend à repousser les ions qui arrivent de la source d'ions ECR, ce qui pose aussi des problèmes d'inhomogénéité dans le procédé d'implantation ionique de l'objet à traiter. Dans le cas où l'objet à traiter est conducteur de l'électricité, ce problème est moins présent dans la mesure où certains au moins des électrons libres ou faiblement liés du matériau dans lequel est réalisé l'objet à traiter peuvent se recombiner avec les ions implantés. Par contre, dans le cas où l'objet à traiter est réalisé en un matériau non conducteur de l'électricité, le phénomène de recombinaison entre électrons et ions mono- ou multichargés ne se produit pas, et garantir une distribution homogène des ions à la surface de l'objet à traiter est difficile. Un procédé d'implantation d'ions est décrit dans le document WO2015/176850 A1.

Résumé de l'invention

La présente invention a pour but de résoudre les problèmes mentionnés ci-dessus ainsi que d'autres encore en procurant un procédé d'implantation d'ions à la surface d'un objet à traiter permettant notamment de garantir une répartition homogène de ces ions sur la surface de l'objet.

A cet effet, la présente invention concerne un procédé d'implantation d'ions mono- ou multichargés sur une surface d'un objet à traiter, ce procédé comprenant l'étape qui consiste à diriger vers la surface de l'objet à traiter un faisceau d'ions produit par une source d'ions mono- ou multichargés du type à résonance cyclotron électronique ECR, le procédé comprenant également l'étape qui consiste à produire au moins un faisceau d'électrons primaires et à diriger ce faisceau d'électrons primaires de façon qu'il passe à travers le faisceau d'ions multichargés.

Le procédé de l'invention comprend également une étape qui consiste à produire un faisceau d'électrons secondaires par réflexion du faisceau d'électrons primaires sur une cible après que ceux-ci aient traversé le faisceau d'ions, la cible étant orientée de telle sorte que le faisceau d'électrons secondaires tombe sur la surface de l'objet à traiter.

Selon une autre caractéristique de l'invention, l'objet à traiter est réalisé en un matériau non conducteur de l'électricité. Le matériau dans lequel l'objet à traiter est réalisé est choisi dans le groupe formé par les saphirs naturels et synthétiques, les verres minéraux, les polymères et les céramiques.

Selon une autre caractéristique de l'invention, l'objet à traiter est réalisé en un matériau conducteur de l'électricité. Il s'agit notamment des alliages métalliques cristallins ou amorphes, et des métaux précieux et non précieux.

Selon encore une autre caractéristique de l'invention, le matériau dans lequel l'objet à traiter est réalisé est choisi dans le groupe formé par les saphirs naturels et synthétiques, les verres minéraux, les polymères, les alliages métalliques cristallins ou amorphes, les céramiques et les métaux précieux et non précieux.

Selon encore une autre caractéristique de l'invention, les atomes qui peuvent être implantés dans la surface de l'objet à traiter au moyen de la source d'ions mono- ou multichargés du type à résonance cyclotron électronique ECR sont choisis dans le groupe formé par l'azote N, le carbone C, l'oxygène O, l'argon Ar, l'hélium He et le néon Ne.

Selon encore une autre caractéristique de l'invention, les atomes d'azote sont obtenus à partir de l'ionisation d'un gaz précurseur diazote, les atomes de carbone sont obtenus à partir de l'ionisation d'un gaz précurseur méthane, et les atomes d'oxygène sont obtenus par ionisation d'un gaz précurseur dioxygène.

Selon encore une autre caractéristique de l'invention, on mesure à distance et en temps réel la température de la surface de l'objet à traiter. Un capteur de température bien adapté pour la mesure de la température de la surface d'un objet en saphir est celui commercialisé par la société française LumaSense Technolgies sous la référence IN 5/9 Plus.

Selon encore une autre caractéristique de l'invention, on mesure en temps réel le potentiel électrique de la surface de l'objet à traiter ou bien le potentiel électrique d'une table qui porte l'objet à traiter.

Grâce à la présente invention, il est ainsi notamment possible de contrôler la charge des ions multichargés avant leur impact avec la surface de l'objet à traiter.

On comprend en effet qu'en dirigeant au moins un faisceau d'électrons primaires vers le faisceau d'ions multichargés positivement (ou cations), au moins une partie des électrons va se recombiner avec les cations du faisceau. Cette recombinaison va provoquer une réduction, voire une annulation de la charge électrique des cations, de sorte que, très souvent, ce sont des particules neutres qui, emportées par leur énergie cinétique, vont venir frapper la surface de l'objet à traiter.

La réduction ou l'annulation de la charge électrique des ions mono- ou multichargés du faisceau a deux conséquences très positives : d'une part, les ions ont moins tendance à se repousser électrostatiquement, de sorte que le faisceau d'ions diverge moins ; d'autre part, le potentiel électrique de la surface de l'objet à traiter et/ou le potentiel électrique de la table sur laquelle l'objet à traiter est posé est moins élevé, de sorte que la surface de l'objet à traiter et la table ont moins tendance à repousser les ions qui arrivent de la source ECR. Il est ainsi possible de maîtriser de manière plus précise l'énergie cinétique des atomes (chargés électriquement ou pas) qui frappent la surface de l'objet à traiter, et donc de contrôler précisément la qualité du revêtement formé sur la surface de l'objet à traiter.

La maîtrise de la qualité et de l'homogénéité du revêtement de la surface de l'objet à traiter est encore améliorée grâce à l'utilisation d'un faisceau d'électrons secondaires obtenus après rebond des électrons du faisceau primaire sur une cible dont l'orientation est choisie de façon que les électrons secondaires viennent frapper la surface de l'objet à traiter. En tombant sur la surface de l'objet à traiter, ces électrons secondaires se recombinent avec les ions multichargés implantés dans la surface, en réduisant ou en annulant la charge électrostatique de ceux-ci, ce qui contribue également à une réduction du potentiel électrostatique de la surface de l'objet à traiter et de la table qui le supporte, et donc à une réduction du phénomène de repoussement des ions multichargés par cette surface.

Enfin, en contrôlant le potentiel électrique de la surface de l'objet à traiter et/ou la température de cet objet, on améliore encore plus la précision de contrôle de l'énergie cinétique des atomes (ionisés ou pas) frappant la surface de l'objet à traiter.

Brève description des figures

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :

- la figure 1, déjà citée, est vue schématique d'une source d'ions multichargés du type à résonance cyclotron électronique ECR selon l'art antérieur ;

- la figure 2 est une vue schématique qui illustre un faisceau d'ions à la sortie de la source d'ions mono- ou multichargés du type à résonance cyclotron électronique ECR illustrée à la figure 1 ;

- la figure 3 est une vue schématique d'une installation d'implantation d'ions mono- ou multichargés à la surface d'un objet à traiter selon l'invention, et

- la figure 4 est une vue schématique qui illustre un faisceau d'ions à la sortie de l'installation d'implantation d'ions multichargés selon l'invention illustrée à la figure 3.

Description détaillée d'un mode de réalisation de l'invention

La présente invention procède de l'idée générale inventive qui consiste à annuler en tout ou partie la charge électrostatique d'ions produits par une source d'ions mono- ou multichargés du type à résonance cyclotron électronique ECR avant que ces ions ne frappent la surface de l'objet à traiter. En réduisant la charge électrostatique de ces ions, ces derniers se repoussent moins les uns les autres, de sorte que le faisceau qu'ils forment diverge moins. De même, les atomes (neutres ou ionisés) qui frappent la surface de l'objet à traiter sont moins repoussés par les ions déjà implantés dans cette surface, de sorte que l'on obtient un revêtement de la surface de l'objet à traiter plus homogène. Pour atteindre ce résultat, la présente invention enseigne de diriger un faisceau d'électrons vers le faisceau d'ions. En traversant le faisceau d'ions, les électrons se recombinent avec ces ions et réduisent ou annulent la charge électrostatique de ces derniers. Pour renforcer cet effet, la présente invention propose de placer une cible sur le trajet des électrons après que ceux-ci aient traversé le faisceau d'ions, de façon que les électrons soient redirigés vers la surface de l'objet à traiter et contribuent eux-aussi à la réduction ou à l'annulation des charges électrostatiques des ions déjà implantés dans la surface de l'objet à traiter. La présente invention a pour but de traiter la surface d'objets par implantation ionique avec annulation de charge en vue d'améliorer les propriétés physiques, notamment mécaniques (augmentation de la dureté de la surface des objets) et optiques (diminution de la réflectivité de la surface des objets réalisés en un matériau transparent).

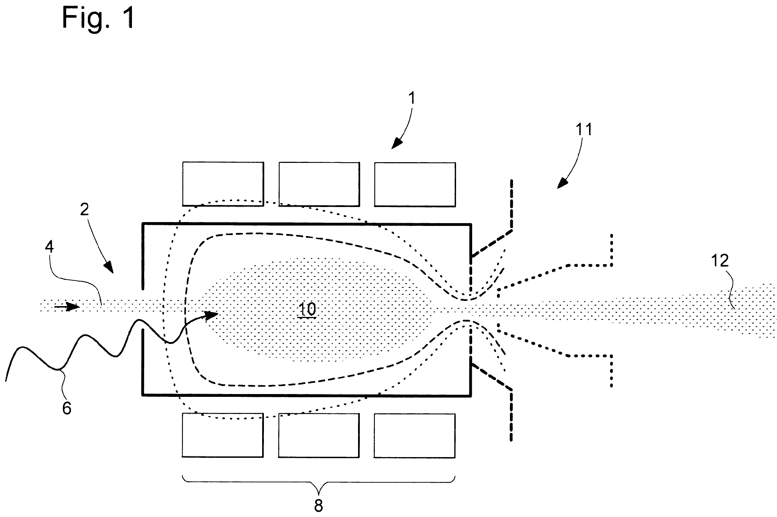

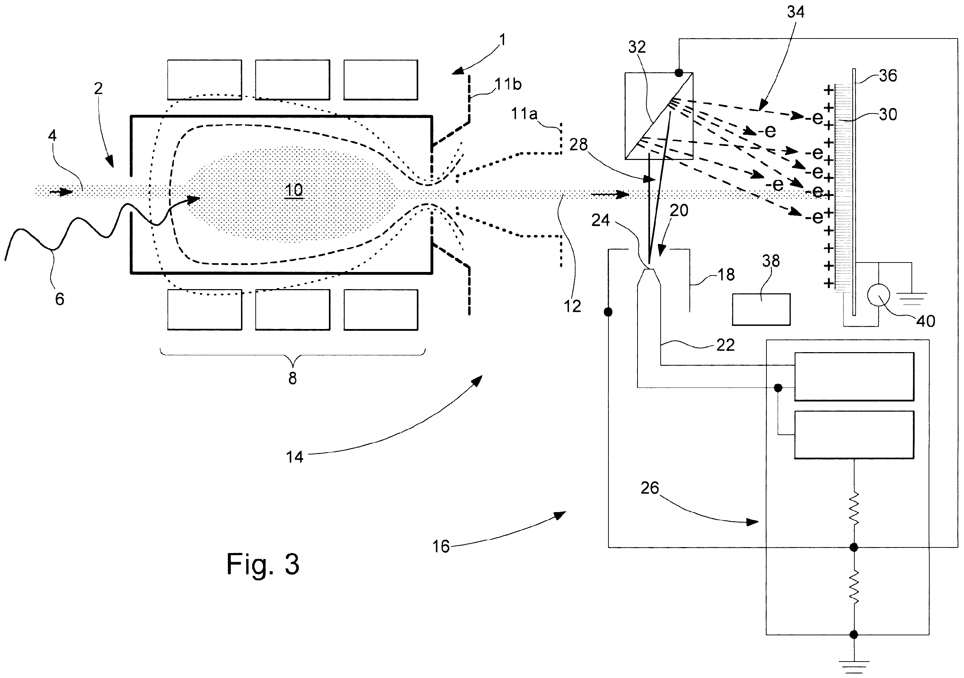

La figure 3 est une vue schématique d'une installation d'implantation d'ions multichargés à la surface d'un objet à traiter selon l'invention. Désignée dans son ensemble par la référence numérique générale 14, cette installation d'implantation d'ions comprend une source d'ions ECR 1 du même type que celle illustrée à la figure 1.

Selon l'invention, on associe à cette source d'ions ECR 1 un canon à électrons désigné dans son ensemble par la référence numérique générale 16. Comme cela est connu, un canon à électrons est un dispositif permettant de produire un faisceau d'électrons par extraction des électrons d'un matériau conducteur vers le vide dans lequel ils sont accélérés par un champ électrique.

Dans le cas qui nous intéresse, on utilise de préférence un canon à électrons à émission de champ froid. A cet effet, le canon à électrons 16 comprend une anode 18, par exemple en graphite, dans laquelle est ménagé un orifice 20, et une cathode métallique 22 sous la forme d'une pointe 24 très fine. On applique au moyen d'un générateur électrique 26 une haute tension électrique entre l'anode 18 et la cathode métallique 22. Sous l'effet de cette haute tension, on produit par effet de pointe à l'extrémité de la cathode métallique 22 un champ électrique très intense. Ce champ électrique intense permet d'extraire par effet tunnel des électrons de la pointe 24 de la cathode métallique 22 et de les accélérer de manière à créer un faisceau d'électrons 28 qui se propage en passant à travers l'orifice 20 ménagé dans l'anode 18. Pour des raisons qui apparaîtront ci-dessous, les électrons émis par le canon à électrons 16 seront appelés électrons primaires.

Selon une variante, l'extraction des électrons de la pointe 24 de la cathode métallique 22 peut être assistée thermiquement.

Selon l'invention, le faisceau d'électrons 28 produit par le canon à électrons 16 est orienté de façon à passer à travers le faisceau d'ions 12. En traversant le faisceau d'ions 12, une partie des électrons primaires se recombine avec les ions, ce qui provoque une réduction, voire une annulation de la charge électrique de ces ions, de sorte que, très souvent, ce sont des atomes neutres (ou tout du moins avec une charge électrostatique moindre) qui, emportés par leur énergie cinétique, vont venir frapper la surface d'un objet à traiter 30.

Selon une caractéristique complémentaire de l'invention, on dispose sur le trajet du faisceau d'électrons primaires 28 une cible 32 sur laquelle les électrons primaires qui ne se sont pas recombinés avec les ions après avoir traversé le faisceau d'ions 12 tombent. La cible 32 est orientée de façon qu'un faisceau d'électrons secondaires 34 produit par la collision entre les électrons du faisceau d'électrons primaires 28 et la cible 32 vienne frapper la surface de l'objet à traiter 30 et une table 36 sur laquelle est posé l'objet à traiter 30. Dans ce cas aussi, les électrons du faisceau d'électrons secondaires 34 annulent ou réduisent la charge électrostatique des ions implantés dans la surface de l'objet à traiter.

Selon encore une autre caractéristique de l'invention, on mesure à distance et en temps réel la température de la surface de l'objet à traiter 30 au moyen d'un capteur de température 38. Un capteur de température bien adapté pour la mesure de la température de la surface d'un objet en saphir est celui commercialisé par la société française LumaSense Technolgies sous la référence IN 5/9 Plus.

Selon encore une autre caractéristique de l'invention, on mesure en temps réel le potentiel électrique de la surface de l'objet à traiter 30 ou bien le potentiel électrique de la table 36 qui porte l'objet à traiter 30 au moyen d'un appareil 40 de mesure de la tension électrique.

L'invention concerne également une installation d'implantation d'ions mono- ou multichargés dans une surface d'un objet à traiter, cette installation comprenant une source d'ions ECR 1 et un canon à électrons 16, la source d'ions ECR 1 produisant un faisceau d'ions 12 et le canon à électrons produisant un faisceau d'électrons primaires 28, la source d'ions ECR 1 et le canon à électrons 16 étant agencés de façon que le faisceau d'électrons primaires 28 intercepte le faisceau d'ions 12.

L'installation d'implantation d'ions mono- ou multichargés comprend également une cible 32 placée sur le trajet du faisceau d'électrons primaires 28 après que celui-ci ait traversé le faisceau d'ions 12. La cible 32 est orientée de façon qu'un faisceau d'électrons secondaires 34 produit par la collision entre les électrons du faisceau d'électrons primaires 28 et la cible 32 vienne frapper la surface de l'objet à traiter 30 et une table 36 sur laquelle est posé l'objet à traiter 30.

L'installation d'implantation d'ions mono- ou multichargés selon l'invention comprend également un capteur de température 38 pour mesurer à distance et en temps réel la température de la surface de l'objet à traiter 30.

L'installation d'implantation d'ions mono- ou multichargés selon l'invention comprend également un appareil 40 de mesure du potentiel électrique de la surface de l'objet à traiter 30 et/ou de la table 36 qui porte l'objet à traiter 30.

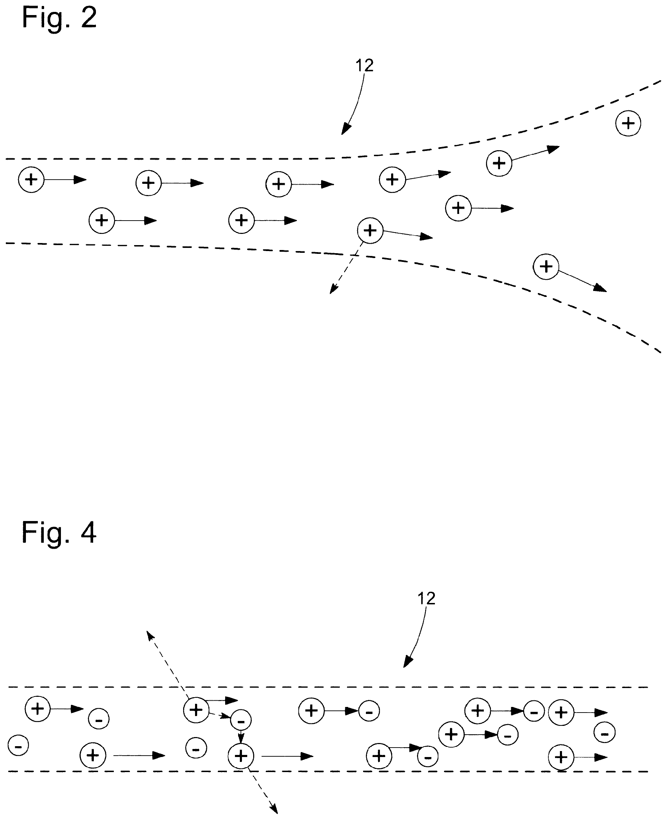

L'aspect du faisceau d'ions 12 produit en sortie de la source d'ions ECR 1 après interception par le faisceau d'électrons primaires 28 est illustré à la figure 4 annexée à la présente demande de brevet. On remarque que ce faisceau d'ions 12 ne diverge que peu, voire même pas du tout, à sa sortie de la source d'ions ECR 1, ce qui s'explique par le fait que la charge électrique d'un grand nombre d'ions (notés « + ») s'annule ou se réduit par recombinaison des électrons (notés « - ») du faisceau d'électrons primaires 28 avec les ions du faisceau d'ions 12. Comme la divergence du faisceau d'électrons primaires 28 est au moins fortement réduite, l'homogénéité de la répartition des ions multichargés à la surface de l'objet à traiter 30 est sensiblement améliorée.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées. On notera en particulier que la dose d'implantation ionique utilisée se trouve dans un intervalle compris entre $1*10^{16}$ ions/cm$^2$ et $15*10^{16}$ ions/cm$^2$

et que la tension d'accélération des ions multichargés est comprise entre 7,5 kV et 35 kV. On comprendra également que la présente invention s'applique tout particulièrement mais non exclusivement au traitement de surface d'objets en saphir (naturel ou synthétique) pour la production de verres de montres. Grâce au procédé d'implantation ionique selon l'invention, on diminue significativement la quantité de lumière incidente réfléchie par de tels verres, ce qui améliore significativement la lisibilité des informations affichées par les organes indicateurs (aiguilles, quantième, décors) situés sous de tels verres. La présente invention s'applique également à d'autres types de matériaux (par exemple céramiques ou métalliques cristallins ou amorphes) dont les propriétés mécaniques, notamment la résistance aux rayures, sont grandement améliorées lorsqu'on leur applique le procédé d'implantation ionique avec neutralisation de charges. On notera aussi que le faisceau d'électrons secondaires comprend à la fois des électrons du faisceau d'électrons primaire et des électrons arrachés à la cible par les électrons du faisceau d'électrons primaire. On notera enfin que, selon l'invention, la source d'ions ECR est en mesure de produire des ions monochargés ou multichargés, c'est-à-dire des ions dont le degré d'ionisation est supérieur ou égal à 1, le faisceau d'ions pouvant comprendre des ions présentant tous le même degré d'ionisation, ou pouvant résulter d'un mélange d'ions présentant des degrés d'ionisation différents.

Nomenclature

| | |
|---|---|
| 1. | Source d'ions du type à résonance cyclotron électronique ECR |
| 2. | Etage d'injection |
| 4. | Volume de gaz à ioniser |
| 6. | Onde hyperfréquence |
| 8. | Etage de confinement magnétique |
| 10. | Plasma |
| 11. | Etage d'extraction |
| 11a. | Anode |
| 11b. | Cathode |
| 12. | Faisceau d'ions |
| 14. | Dispositif d'implantation d'ions |
| 16. | Canon à électrons |
| 18. | Anode |
| 20. | Orifice |
| 22. | Cathode métallique |
| 24. | Pointe |
| 26. | Générateur électrique |
| 28. | Faisceau d'électrons primaires |
| 30. | Objet à traiter |
| 32. | Cible |
| 34. | Faisceau d'électrons secondaires |
| 36. | Table |
| 38. | Capteur de température |
| 40. | Appareil de mesure de la tension électrique. |

**Revendications**

1. Procédé d'implantation d'ions mono- ou multichargés sur une surface d'un objet à traiter (30), ce procédé comprenant l'étape qui consiste à diriger vers la surface de l'objet à traiter (30) un faisceau d'ions (12) produit par une source d'ions (1) du type à résonance cyclotron électronique ECR, le procédé comprenant également les étapes qui consistent à :

   • produire au moins un faisceau d'électrons primaires (28) et à diriger ce faisceau d'électrons primaires (28) de façon qu'il passe à travers le faisceau d'ions (12), et
   • produire un faisceau d'électrons secondaires (34) par réflexion du faisceau d'électrons primaires (28) sur une cible (32) après que celui-ci ait traversé le faisceau d'ions (12), la cible (32) étant orientée de telle sorte que le faisceau d'électrons secondaires (34) tombe sur la surface de l'objet à traiter (30).

2. Procédé selon la revendication 1, **caractérisé en ce que** l'objet à traiter (30) est réalisé en un matériau non conducteur de l'électricité ou semi-cond ucteur.

3. Procédé selon l'une des revendications 1 et 2, **caractérisé en ce que** le matériau dans lequel l'objet à traiter (30) est réalisé est choisi dans le groupe formé par les saphirs naturels et synthétiques, les verres minéraux, les polymères et les céramiques.

4. Procédé selon l'une des revendications 1 et 2, **caractérisé en ce que** le matériau dans lequel l'objet à traiter (30) est réalisé est en un matériau conducteur de l'électricité.

5. Procédé selon la revendication 4, **caractérisé en ce que** le matériau dans lequel l'objet à traiter (30) est réalisé est choisi dans le groupe formé par les alliages métalliques cristallins ou amorphes, les céramiques et les métaux précieux et non précieux.

6. Procédé selon l'une des revendications 1 à 5, **caractérisé en ce que** les atomes qui sont implantés dans la surface de l'objet à traiter (30) au moyen de la source d'ions multichargés du type à résonance cyclotron électronique ECR (1) sont choisis dans le groupe formé par l'azote N, le carbone C, l'oxygène O, l'argon Ar, l'hélium He et le néon Ne.

7. Procédé selon la revendication 6, **caractérisé en ce que** les atomes d'azote sont obtenus à partir de l'ionisation d'un gaz précurseur diazote, les atomes de carbone sont obtenus à partir de l'ionisation d'un gaz précurseur méthane, et les atomes d'oxygène sont obtenus par ionisation d'un gaz précurseur dioxygène.

8. Procédé selon l'une des revendications 1 à 7, **caractérisé en ce que** l'on mesure à distance et en temps réel la température de la surface de l'objet à traiter (30).

9. Procédé selon l'une des revendications 1 à 8, **caractérisé en ce que** l'on mesure en temps réel le potentiel électrique de la surface de l'objet à traiter (30) ou bien le potentiel électrique d'une table (36) qui porte l'objet à traiter (30).

10. Procédé selon l'une des revendications 1 à 9, **caractérisé en ce que** l'on traite la surface de l'objet à traiter (30) au moyen d'au moins une dose d'implantation ionique qui se trouve dans un intervalle compris entre $1*10^{16}$ ions/cm$^2$ et $15*10^{16}$ ions/cm$^2$, et **en ce que** la tension d'accélération des ions multichargés est comprise entre 7,5 kV et 35 kV.

11. Installation d'implantation d'ions mono- ou multichargés dans une surface d'un objet à traiter (30), cette installation comprenant une source d'ions ECR (1) et un canon à électrons (16), la source d'ions ECR (1) produisant un faisceau d'ions (12) et le canon à électrons (16) produisant un faisceau d'électrons primaires (28), la source d'ions ECR (1) et le canon à électrons (16) étant agencés de façon que le faisceau d'électrons primaires (28) intercepte le faisceau d'ions (12), l'installation d'implantation d'ions mono- ou multichargés comprenant en outre une cible (32) placée sur le trajet du faisceau d'électrons primaires (28) après que celui-ci ait traversé le faisceau d'ions (12), la cible (32) étant orientée de façon qu'un faisceau d'électrons secondaires (34) produit par la collision entre les électrons du faisceau d'électrons primaires (28) qui ne se sont pas recombinés avec les ions du faisceau d'ions (12) et la cible (32) vienne frapper la surface de l'objet à traiter (30).

12. Installation d'implantation d'ions mono- ou multichargés selon la revendication 11, **caractérisée en ce que** le faisceau d'électrons secondaires (34) vient également frapper une table (36) sur laquelle est posé l'objet à traiter (30).

13. Installation d'implantation d'ions mono- ou multichargés selon l'une des revendications 11 et 12, **caractérisée en ce qu'**elle comprend un capteur de température (38) pour mesurer à distance et en temps réel la température de la surface de l'objet à traiter (30).

14. Installation d'implantation d'ions mono- ou multichargés selon l'une des revendications 11 à 13, **caractérisée en ce qu'**elle comprend un appareil (40) de mesure du potentiel électrique de la surface de l'objet à traiter (30) et/ou de la table (36) qui porte l'objet à traiter (30).

**Patentansprüche**

1. Verfahren zum Implantieren einfach oder mehrfach geladener Ionen an einer Oberfläche eines zu bearbeitenden Objekts (30), wobei dieses Verfahren einen Schritt umfasst, der darin besteht, einen von einer Ionenquelle (1) des Typs mit Elektron-Zyklotronresonanz, EZR, erzeugten Ionenstrahl (12) auf die Oberfläche des zu bearbeitenden Objekts (30) zu richten, wobei das Verfahren ferner die folgenden Schritte umfasst:

   - Erzeugen mindestens eines Primärelektronenstrahls (28) und Lenken dieses Primärelektronenstrahls (28), derart, dass er den Ionenstrahl (12) durchquert, und
   - Erzeugen eines Sekundärelektronenstrahls (34) durch Reflektieren des Primärelektronenstrahls (28) an einem Target (32), nachdem dieser den Ionenstrahl (12) durchquert hat, wobei das Target (32) derart ausgerichtet ist, dass der Sekundärelektronenstrahl (34) auf die Oberfläche des zu bearbeitenden Objekts (30) trifft.

2. Verfahren nach Anspruch 1, **dadurch gekennzeichnet, dass** das zu bearbeitende Objekt (30) aus einem nicht elektrisch leitenden oder halbleitenden Material hergestellt ist.

3. Verfahren nach einem der Ansprüche 1 und 2, **dadurch gekennzeichnet, dass** das Material, aus dem das zu bearbeitende Objekt (30) hergestellt ist, aus der Gruppe ausgewählt ist, die aus natürlichen und synthetischen Saphiren, Mineralgläsern, Polymeren und Keramiken gebildet ist.

4. Verfahren nach einem der Ansprüche 1 und 2, **dadurch gekennzeichnet, dass** das Material, aus dem das zu bearbeitende Objekt (30) hergestellt ist, ein elektrisch leitendes Material ist.

5. Verfahren nach Anspruch 4, **dadurch gekennzeichnet, dass** das Material, aus dem das zu bearbeitende Objekt (30) hergestellt ist, aus der Gruppe ausgewählt ist, die aus kristallinen oder amorphen Metalllegierungen, Keramiken sowie Edelmetallen und Nichtedelmetallen gebildet ist.

6. Verfahren nach einem der Ansprüche 1 bis 5, **dadurch gekennzeichnet, dass** die in die Oberfläche des zu bearbeitenden Objekts (30) mittels der Quelle (1) für mehrfach geladene Ionen des Typs mit Elektron-Zyklotronresonanz, EZR, implantierten Atome aus der Gruppe ausgewählt sind, die aus Stickstoff N, Kohlenstoff C, Sauerstoff O, Argon Ar, Helium He und Neon Ne gebildet ist.

7. Verfahren nach Anspruch 6, **dadurch gekenn-**

**zeichnet, dass** die Stickstoffatome aus der Ionisation eines Distickstoff-Vorläufergases erhalten werden, die Kohlenstoffatome aus der Ionisation eines Methan-Vorläufergases erhalten werden und die Sauerstoffatome aus der Ionisation eines Disauerstoff-Vorläufergases erhalten werden.

8. Verfahren nach einem der Ansprüche 1 bis 7, **dadurch gekennzeichnet, dass** die Oberflächentemperatur des zu bearbeitenden Objekts (30) in einem Abstand und in Echtzeit gemessen wird.

9. Verfahren nach einem der Ansprüche 1 bis 8, **dadurch gekennzeichnet, dass** das elektrische Potential der Oberfläche des zu bearbeitenden Objekts (30) oder das elektrische Potential eines das zu bearbeitende Objekt (30) tragenden Tisches (36) in Echtzeit gemessen wird.

10. Verfahren nach einem der Ansprüche 1 bis 9, **dadurch gekennzeichnet, dass** die Oberfläche des zu bearbeitenden Objekts (30) mit mindestens einer Ionenimplantationsdosis behandelt wird, die im Bereich von $1*10^{16}$ Ionen/cm$^2$ bis $15*10^{16}$ Ionen/cm$^2$ liegt und dass die Beschleunigungsspannung der mehrfach geladenen Ionen zwischen 7,5 kV und 35 kV liegt.

11. Anlage zum Implantieren einfach oder mehrfach geladener Ionen an einer Oberfläche eines zu bearbeitenden Objekts (30), wobei die Anlage eine EZR-Ionenquelle (1) und eine Elektronenkanone (16) umfasst, die EZRIonenquelle (1) einen Ionenstrahl (12) erzeugt und die Elektronenkanone (16) einen Primärelektronenstrahl (28) erzeugt, wobei die EZR-Ionenquelle (1) und die Elektronenkanone (16) so angeordnet sind, dass der Primärelektronenstrahl (28) den Ionenstrahl (12) abfängt, die Anlage für die Implantation einfach oder mehrfach geladener Ionen ferner ein Target (32) umfasst, das in der Bahn des Primärelektronenstrahls (28) angeordnet ist, nachdem dieser den Ionenstrahl (12) durchquert hat, und das Target (32) derart ausgerichtet ist, dass ein durch die Kollision zwischen den Elektronen des Primärelektronenstrahls (28), die nicht mit den Ionen des Ionenstrahls (12) rekombinieren, und dem Target (32) erzeugter Sekundärelektronenstrahl (34) auf die Oberfläche des zu bearbeitenden Objekts (30) auftrifft.

12. Anlage zum Implantieren einfach oder mehrfach geladener Ionen nach Anspruch 11, **dadurch gekennzeichnet, dass** der Sekundärelektronenstrahl (34) ferner auf einen Tisch (36) auftrifft, auf dem das zu bearbeitende Objekt (30) angeordnet ist.

13. Anlage zum Implantieren einfach oder mehrfach geladener Ionen nach einem der Ansprüche 11 und 12, **dadurch gekennzeichnet, dass** sie einen Temperatursensor (38) umfasst, um die Temperatur der Oberfläche des zu bearbeitenden Objekts (30) in einem Abstand und in Echtzeit zu messen.

14. Anlage zum Implantieren einfach oder mehrfach geladener Ionen nach einem der Ansprüche 11 bis 13, **dadurch gekennzeichnet, dass** sie eine Vorrichtung (40) zum Messen des elektrischen Potentials der Oberfläche des zu bearbeitenden Objekts (30) und/oder des das zu bearbeitende Objekt (30) tragenden Tisches (36) umfasst.

**Claims**

1. Method for implanting single or multiply charged ions into a surface of an object (30) to be treated, said method including the step that consists in directing towards the surface of the object (30) to be treated an ion beam (12) produced by an ion source (1) of the electronic cyclotron resonance ECR type, the method also including the steps consisting in:

   • producing at least one primary electron beam (28) and directing said primary electron beam (28) so that it passes through the ion beam (12), and
   • producing a secondary electron beam (34) by reflection of the primary electron beam (28) onto a target (32) once said primary electron beam has traversed the ion beam (12), the target (32) being oriented such that the secondary electron beam (34) falls onto the surface of the object (30) to be treated.

2. Method according to claim 1, **characterized in that** the object (30) to be treated is made of a non-electrically conductive or semiconductor material.

3. Method according to any of claims 1 and 2, **characterized in that** the material from which the object (30) to be treated is made is chosen from the group formed by natural and synthetic sapphires, mineral glasses, polymers and ceramics.

4. Method according to any of claims 1 and 2, **characterized in that** the material from which the object (30) to be treated is made is an electrically conductive material.

5. Method according to claim 4, **characterized in that** the material from which the object (30) to be treated is made is chosen from the group formed by crystalline or amorphous metal alloys, ceramics and precious and non-precious metals.

6. Method according to any of claims 1 to 5, **charac-** terized in that the atoms that are implanted into the surface of the object (30) to be treated by means of the single or multiply charged ECR ion source (1) are chosen from the group formed by nitrogen N, carbon C, oxygen O, argon Ar, helium He and neon Ne.

7. Method according to claim 6, **characterized in that** the nitrogen atoms are obtained by ionisation of a dinitrogen precursor gas, the carbon atoms are obtained by ionisation of a methane precursor gas, and the oxygen atoms are obtained by ionisation of a dioxygen precursor gas.

8. Method according to any of claims 1 to 7, **characterized in that** the surface temperature of the object (30) to be treated is measured remotely and in real time.

9. Method according to any of claims 1 to 8, **characterized in that** the electrical potential of the surface of the object (30) to be treated or the electrical potential of a table (36) that supports the object (30) to be treated is measured in real time.

10. Method according to any of claims 1 to 9, **characterized in that** the surface of the object (30) to be treated is treated by means of at least one ion implantation dose that falls within a range comprised between $1*10^{16}$ ions/cm$^2$ and $15*10^{16}$ ions/cm$^2$ and **in that** the single or multiply charged ion acceleration voltage is comprised between 7.5 kV and 35 kV.

11. Installation for implanting single or multiply charged ions into a surface of an object (30) to be treated, said device comprising an ECR ion source (1) and an electron gun (16), the ECR ion source (1) producing an ion beam (12) and the electron gun (16) producing a primary electron beam (28), the ECR ion source (1) and the electron gun (16) being arranged such that the primary electron beam (28) intercepts the ion beam (12), the single or multiply charged ion implantation device further comprising a target (32) placed on the path of the primary electron beam (28) once the latter has passed through the ion beam (12), the target (32) being oriented such that a secondary electron beam (34), produced by the collision between the electrons of the primary electron beam (28) which have not recombined with the ions of the ion beam (12) and the target (32), impinges on the surface of the object (30) to be treated.

12. Installation for implanting single or multiply charged ions according to claim 11, **characterized in that** the secondary electron beam (34) also impinges on a table (36) on which the object (30) to be treated is placed.

**13.** Installation for implanting single or multiply charged ions according to any of claims 11 and 12, **characterized in that** the device also includes a temperature sensor (38) for measuring remotely and in real time the surface temperature of the object (30) to be treated.

**14.** Installation for implanting single or multiply charged ions according to any of claims 11 to 13, **characterized in that** the device includes an instrument (40) for measuring the electrical potential of the surface of the object (30) to be treated and/or of the table (36) that supports the object (30) to be treated.

Fig. 1

EP 3 453 045 B1

Fig. 2

12

Fig. 4

12

Fig. 3

EP 3 453 045 B1

**RÉFÉRENCES CITÉES DANS LA DESCRIPTION**

**Documents brevets cités dans la description**

- WO 2015176850 A1